(19) Europäisches Patentamt
European Patent Office
Office européen des brevets

(11) EP 3 264 124 A1

(12) **EUROPEAN PATENT APPLICATION**

(43) Date of publication:
**03.01.2018 Bulletin 2018/01**

(51) Int Cl.:
*G01R 33/28* [(2006.01)]    *G01R 33/62* [(2006.01)]
*G01N 24/12* [(2006.01)]    *G01R 33/32* [(2006.01)]

(21) Application number: **16177281.9**

(22) Date of filing: **30.06.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ETH Zurich
8092 Zurich (CH)**

(72) Inventors:
• **BOSS, Jens
  6033 Buchrain (CH)**
• **LORETZ, Michael
  8050 Zürich (CH)**
• **TAKAHASHI, Hiroki
  8053 Zürich (CH)**
• **DEGEN, Christian
  8049 Zürich (CH)**

(54) **HYPERPOLARIZATION OF NUCLEAR SPINS USING NV CENTERS IN DIAMOND**

(57)     A method for polarizing nuclear target spins in an analyte employs diamonds (12) comprising a plurality of nitrogen-vacancy (NV) centers and a plurality of substitutional nitrogen centers (P1). A liquid sample comprising the analyte is brought into contact with the diamond surface. The sample is frozen, and the NV centers are irradiated with light to polarize the electron spins in the NV centers. Polarization transfer is carried out from the NV centers to the P1 centers in the diamond, and direct or indirect polarization transfer is carried out from the P1 centers in the diamond to the target spins while the sample (13) is in a frozen state. Subsequently the sample is melted and transferred to a magnetic resonance probe.

FIG. 8

**Description**

TECHNICAL FIELD

The present invention relates to a method and an apparatus for efficient hyperpolarization of spins using nitrogen vacancy centers in diamond, and to a spin polarizer cell that is specifically configured to be used in such a method and apparatus.

PRIOR ART

Magnetic resonance is widely used in vast areas of science and industries as a spectroscopic tool for analyzing inorganic and organic materials, biological systems, etc. It is also used as an imaging tool for materials as well as clinical applications. Compared to other spectroscopic techniques, however, the sensitivity of magnetic resonance is extremely low due to the small Zeeman splitting and resultant small thermal (Boltzmann) polarization. For instance, the spin polarization of $^1$H spins at 7 T and room temperature is only approximately 0.0024%.

There have been many attempts in the prior art to achieve hyperpolarization, i.e., a polarization that is much higher than the typical thermal polarization in a given magnetic field. A known group of hyperpolarization methods employs nitrogen vacancy (NV) centers in diamond, which can be efficiently spin-polarized by optical irradiation.

US 2016/0054402 A1 discloses a hyperpolarization method for nuclear and electron spins in fluidic samples. The fluidic sample is introduced into a channel. At least one surface of the channel is a diamond surface comprising a plurality of nitrogen-vacancy (NV) centers implanted within 10 nm of the surface. The NV centers are exposed to a magnetic field while the sample is in the channel. The NV centers are optically pumped to produce polarized electron spins in the NV centers. The polarized electron spins of the NV centers are permitted to induce spin polarization in the fluidic sample. A direct polarization transfer mechanism from the near-surface NV centers to the target spins in the fluidic sample is employed. A similar method is disclosed in D. Abrams, et al., Dynamic Nuclear Spin Polarization of Liquids and Gases in Contact with Nanostructured Diamond, Nano Lett., 14, 2471-2478 (2014)

US 2016/0061914 A1 discloses a hyperpolarization method for $^{13}$C spins in a diamond. NV centers in the diamond are optically pumped to produce polarized electron spins in the NV centers. The resulting electron spin polarization is directly transferred to $^{13}$C spins in the diamond by standard dynamic nuclear polarization (DNP) protocols. The resulting $^{13}$C polarization in the diamond is further transferred to $^{13}$C spins in molecules which are in contact with the diamond. Q. Chen, et al., Optical hyperpolarization of 13C nuclear spins in nanodiamond ensembles, Phys. Rev. B, 92, 184420 (2015) discloses a similar method.

A similar method is also disclosed in J. P. King, et al., Room-temperature in situ nuclear spin hyperpolarization from optically pumped nitrogen vacancy centres in diamond, Nat. Commun., 6, 8965 (2015).

R. Hanson, et al., Polarization and Readout of Coupled Single Spins in Diamond, Phys. Rev. Lett., 97, 87601 (2006) discloses polarization transfer from a single optically pumped NV center to a single nearby substitutional nitrogen (P1) electronic spin. Hyperpolarization of bulk P1 spins was not demonstrated, and no polarization transfer to additional target spins is proposed.

C. Belthangady, et al., Dressed-State Resonant Coupling between Bright and Dark Spins in Diamond, Phys. Rev. Lett., 110, 157601 (2013) discloses polarization transfer from optically pumped NV centers to the nearby substitutional nitrogen (P1) electronic spins by dressing the spin states with oscillating magnetic fields. The polarization transfer is read out optically, and no polarization transfer to additional target spins is proposed.

SUMMARY OF THE INVENTION

It is an object of the present invention to provide an improved hyperpolarization method employing NV centers in diamond to achieve increased polarization levels of nuclear target spins in a bulk sample.

This object is achieved by a method for hyperpolarization of spins as laid down in Claim 1. A corresponding apparatus is defined in Claim 7. The invention further provides a spin polarizer cell that is specifically configured to be employed in the method of the present invention, as defined in claim 11. Further embodiments of the invention are laid down in the dependent claims.

The present invention provides a method for polarizing nuclear target spins in an analyte, the method comprising:

(a) providing at least one diamond comprising a plurality of nitrogen-vacancy centers and a plurality of substitutional nitrogen centers, the diamond defining a diamond surface;
(b) bringing a sample comprising the analyte into contact with the diamond surface;
(c) irradiating the nitrogen-vacancy centers with light to produce polarized electron spins in the nitrogen-vacancy centers;

(d) inducing polarization transfer from the nitrogen-vacancy centers to substitutional nitrogen (P1) centers in the diamond;

(e) inducing direct or indirect polarization transfer from the substitutional nitrogen (P1) centers in the diamond to the target spins in the analyte; and

(f) optionally repeating steps (c)-(e).

The method of the present invention efficiently increases the sensitivity of magnetic resonance measurements using optically pumped nitrogen vacancy (NV) centers in diamond. The optically pumped NV centers have a high degree of electronic spin polarization. The electronic spin polarization is transferred from the NV centers to electronic spins in nearby substitutional nitrogen defects, in the following referred to as P1 centers. Since the density of P1 centers in a diamond is generally greater than the density of NV centers, the electronic spin polarization at the diamond surface will be increased by this polarization transfer step. The polarization is then further transferred from the electronic spins in the near-surface P1 centers (i.e., P1 centers at a distance of approximately 20 nm or less from the diamond surface) to the target spins in the analyte. The transfer from the near-surface P1 centers to the target spins can be direct or indirect, wherein indirect polarization transfer means that the polarization transfer from the P1 centers to the target spins occurs via additional electronic or nuclear spin species.

A nitrogen-vacancy center (NV center) is a point defect in the diamond lattice. It consists of a nearest-neighbor pair of a nitrogen atom, which substitutes for a carbon atom, and a lattice vacancy. NV centers can be produced from single substitutional nitrogen centers (P1 centers) by irradiation with high-energy radiation such as electron, proton, neutron, ion or gamma irradiation, followed by annealing. An NV center in the negative charge state comprises an unpaired nitrogen electron and an extra electron, which together form a spin S=1 pair. In the present disclosure, all references to NV centers are to be understood as meaning NV centers in the negative charge state (sometimes also called [NV-] centers in the literature). One important property of NV centers is that close to 100% electron spin polarization can be created by optically pumping the NV centers with green laser light, causing the NV centers to be driven into the $m_s = 0$ substate of the ground state.

The polarization transfer from the NV centers to the P1 centers can be induced by applying a static magnetic field to the diamond, so as to match a Zeeman splitting between two electron spin states of the NV centers with the Zeeman splitting of the electronic spins of the P1 centers. Such energy matching facilitates polarization transfer from the NV centers to the P1 centers by flip-flop transitions mediated by the dipolar interaction. In the alternative, the polarization transfer from the NV centers to the P1 centers can be induced by applying a combination of a static magnetic field and microwave irradiation to the diamond, wherein the static magnetic field and the microwave irradiation are applied in such a manner that polarization transfer from the NV centers to the P1 centers is facilitated. There are two possible conditions for this:

1) The microwave irradiation occurs at a frequency that at least approximately matches the difference between an NV electron spin resonance frequency that involves the $m_s = 0$ substate and the electron spin resonance frequency of the P1 centers (expressed mathematically, $\omega_{MW} = |\omega_{NV} - \omega_{P1}|$, where $\omega_{MW}$ is the microwave frequency, $\omega_{NV}$ is one of the NV resonance frequencies involving the $m_s = 0$ substate of the ground state, and $\omega_{P1}$, is the P1 resonance frequency).

2) Hartmann-Hahn matching: The microwave irradiation occurs at two different frequencies, one frequency being the NV electron spin resonance frequency and the other frequency being the P1 electron spin resonance frequency, and the microwave field strength sensed by the electron spins in the NV centers in a rotating frame that rotates at the NV resonance frequency and the microwave field strength sensed by the electron spins in the P1 centers in a rotating frame that rotates at the P1 resonance frequency at least approximately match (expressed mathematically, $B_{1,NV} = B_{1,P1}$ where $B_{1,NV}$ and $B_{1,P1}$ are the strengths of the microwave fields on NV and P1 spins, respectively, in the doubly-rotating frame).

Preferably the sample is brought into contact with the diamond surface while the sample is in a liquid state, and the sample is frozen after it has been brought into contact with the diamond surface. The polarization transfer to the target spins is then induced while the sample is in a frozen state. The sample is subsequently melted again after polarization transfer from the P1 centers to the target spins has been effected. Any subsequent magnetic resonance measurements can then be carried out on the liquid sample.

Freezing the sample reduces sample heating by the laser beam when the NV centers are polarized. Freezing the sample also lengthens the spin-lattice relaxation time of the involved nuclear spin species. Furthermore, the interactions between spins are stronger in solids, and thus the efficiency of polarization transfer is higher in solids. The sample temperature in the frozen state can be, e.g., between 1 K and 273 K. Preferably the sample temperature is lower than 200 K, more preferably lower than 77 K, even more preferably lower than 4 K.

The method can comprise a step of shuttling the sample into a magnetic resonance probe, in particular into a nuclear magnetic resonance (NMR) probe. The magnetic resonance probe is preferably located in a region with a static magnetic field of at least 0.5 T, preferably at least 1 T. Subsequently a magnetic resonance measurement employing the target spins can be carried out with the magnetic resonance probe, in particular, an NMR measurement.

In order to further improve the polarization transfer from the P1 centers in the diamond to the target spins, the diamond surface can be functionalized with radicals, i.e., with molecules having an unpaired electron. The polarization transfer from the substitutional nitrogen (P1) centers in the diamond to the target spins then comprises:

> a first polarization transfer from near-surface substitutional nitrogen (P1) centers in the diamond to the radicals, and
> a second polarization transfer from the radicals to the target spins.

In the alternative or additionally, the liquid sample can comprise radicals and/or nanodiamonds comprising P1 centers, and the polarization transfer from the P1 centers in the diamond to the target spins can comprise:

> a first polarization transfer from near-surface P1 centers in the diamond to the radicals or to the P1 centers in the nanodiamonds, and
> a second polarization transfer from the radicals or from the P1 centers in the nanodiamonds to the target spins.

The polarization transfer to the nuclear target spins can comprise a pulsed or continuous-wave dynamic nuclear polarization (DNP) method. The term "dynamic nuclear polarization" is to be understood as encompassing any method of transferring polarization from electron spins to nuclear spins. A multitude of such methods has become known in the art. A preferred method is the known scheme called integrated solid effect (ISE), wherein a microwave field of strength $B_1$ is applied to electron spins to meet the Hartmann-Hahn matching condition in the rotating frame of the electron spins and the laboratory frame of the nuclear spins, while the microwave frequency or the static magnetic field is swept so that all electron spins can be involved in the polarization transfer process. However, any other known DNP method other than the ISE scheme can be used.

In some embodiments, the light source used for exciting the NV centers is also used to heat the sample. In particular, the light for irradiating the nitrogen-vacancy centers to produce polarized electron spins in the nitrogen-vacancy centers can be obtained from a laser, and the same laser can be used to melt the sample. In this case, no separate heat source is required to melt the sample. In other embodiments, a separate heat source is provided, such as a separate laser, an electric heater or a hot gas stream.

The present invention also provides an apparatus for polarizing nuclear target spins in an analyte, the apparatus comprising:

> a spin polarizer cell comprising at least one diamond, the diamond comprising a plurality of nitrogen-vacancy (NV) centers and a plurality of substitutional nitrogen (P1) centers, the spin polarizer cell being configured to receive a liquid sample comprising the analyte;
> a light source;
> a microwave source;
> a microwave resonator coupled to the microwave source and configured to receive the spin polarizer cell;
> a magnet system configured to create a static magnetic field inside the microwave resonator; and
> a controller configured to control the light source, the microwave source and optionally the magnet in such a manner so as to carry out the following method:
>
>> (a) activating the light source to irradiate the nitrogen-vacancy (NV) centers with light to produce polarized electron spins in the nitrogen-vacancy (NV) centers;
>> (b) operating the microwave source and the magnet in such a manner that polarization transfer from the nitrogen-vacancy (NV) centers to substitutional nitrogen (P1) centers in the diamond is induced;
>> (c) operating the microwave source and the magnet in such a manner that direct or indirect polarization transfer from the substitutional nitrogen (P1) centers in the diamond to the target spins is induced; and
>> (d) optionally repeating steps (a)-(c).

The magnet system can comprise a permanent magnet and/or one or more electromagnets. If the magnet comprises one or more electromagnets, preferably at least one of these electromagnets is operatively connected to the controller to allow a change of the static magnetic field inside the microwave resonator. The magnet system can comprise at least one modulation coil that is configured to sweep the static magnetic field. The modulation coil can be operatively connected to the controller, and the controller can be configured to rapidly ramp a current in the modulation coil so as to create a field sweep.

In particular, in step (b), the controller may be configured to operate the magnet system to create a static magnetic field of approximately 50 mT or to sweep the static magnetic field through a field range that comprises a value of approximately 50 mT. If the magnet system consists only of a permanent magnet creating a field of approximately 50 mT, or of an electromagnet that is set to a fixed field of approximately 50 mT, the controller may simply do nothing. In the alternative, the controller may be configured to set the magnet to any other magnetic field strength or to sweep the magnet through any other magnetic field range, and to simultaneously irradiate the sample with microwaves having a frequency and field strength that facilitates polarization transfer between the electronic spins in the NV centers and the P1 centers by matching their energy splittings in a suitable frame of reference.

In step (c), the controller may be configured to carry out any known DNP scheme, preferably the above-described ISE scheme. In particular, the controller can be configured to operate the microwave source so as to apply microwave irradiation to spin-lock the electron spins in the effective microwave field. The controller can then further be configured to set the magnetic field strength $B_1$ of the microwave field to a value that matches the electron Zeeman splitting in the rotating frame to the nuclear Zeeman splitting in the laboratory frame which is due to the static magnetic field.

The apparatus may further comprise a cooling and heating device for selectively freezing and melting the sample. The controller can then be configured to control the cooling and heating device to carry out the following steps:

operating the cooling and heating device to freeze the sample before polarization transfer from NV centers to the P1 centers in the diamond is induced; and
operating the cooling and heating device to melt the sample after polarization transfer from the P1 centers to the target spins has been effected.

The controller may be a digital controller executing a suitable data processing program. In particular the controller may comprise a microprocessor and a memory storing a data processing program that causes the microprocessor to output instructions to the light source, the microwave source and optionally the magnet so as to carry out the above-described method steps.

The apparatus can further comprise a sample transfer mechanism, the sample transfer mechanism comprising a transfer tube configured to receive the spin polarizer cell, the sample transfer mechanism being configured to transfer the sample container to a magnetic resonance probe. The sample transfer mechanism can further comprise a source of vacuum and/or a source of pressurized gas and at least one valve for selectively connecting the source of vacuum and/or the source of pressurized gas to the transfer tube, so as to selectively apply a vacuum or positive pressure to a portion of the transfer tube.

Preferably the light source is configured to shine the light into the transfer tube along the longitudinal axis of the transfer tube. In particular, the light source can comprise:

a laser for creating a laser beam; and
at least one optical element for directing the laser beam into the transfer tube along its longitudinal axis.

The optical elements can comprise one or more lenses, mirrors or optical fibers.

In other embodiments, the light source can be configured to shine the light into the transfer tube perpendicular to the longitudinal axis.

The cooling and heating device can comprise:

a cooling tube, the cooling tube surrounding the transfer tube so as to define an annular interspace between the transfer tube and the cooling tube; and
a cold gas source configured to pass cold gas into the interspace so as to cool the transfer tube and the spin polarizer cell received therein.

In order to prevent the formation of fog and ice in the transfer tube, the apparatus can comprise a purging device configured to pass a purge gas into a proximal end region of the cooling tube so as to prevent the cold gas from exiting the cooling tube at a proximal end of the cooling tube.

The present invention further provides a spin polarizer cell comprising:

a sample container having at least one wall portion that is transparent to visible light; and
an arrangement of diamonds arranged in the sample container so as to receive a liquid sample there between.

The arrangement of diamonds can, in particular, comprise at least one stack of diamond plates disposed inside the sample container, each diamond plate comprising a plurality of nitrogen-vacancy centers and a plurality of substitutional nitrogen centers, the diamond plates being arranged so as to receive a liquid sample there between. Each diamond plate can be made of a single crystal, of polycrystalline diamond or of nanocrystals. An advantage of single-crystalline diamond plates is that their NV centers have a limited number of well-defined orientations, enabling alignment of NV centers having a selected orientation with the magnetic field. In alternative embodiments, the arrangement of diamonds comprises a loose conglomeration of randomly oriented diamonds, e.g., in the form of a powder. Preferably each diamond in the diamond arrangement is larger than approximately 10 nanometers along all spatial directions, so as to ensure that it contains sufficient numbers of both NV centers and P1 centers.

The sample container may comprise a portion made of glass, in particular, a glass tube closed at both ends by transparent end caps. The sample container may alternatively comprise a capsule made of sapphire, in particular a capsule comprising two transparent sapphire disks that sandwich the diamond plates.

Preferably each diamond plate has a thickness of 0.5 to 100 micrometers. Each diamond plate may comprise a plurality of parallel trenches. Each of the diamond plates can have at least one surface that is functionalized with radicals, as discussed above.

The spin polarizer cell can further contain a sample comprising an analyte having target spins. The sample may in addition comprise radicals or nanodiamonds containing P1 centers, as discussed above.

## BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1    shows a schematic view of a spin polarizer system in accordance with the present invention;
Fig. 2    shows a schematic inside view of the microwave resonator in Fig. 1;
Fig. 3    shows an analyte container in accordance with the present invention;
Fig. 4    shows a schematic illustration of a diamond plate with trenches;
Fig. 5    shows an SEM picture of a diamond surface with etched trenches;
Fig. 6    shows an energy level diagram of NV centers and P1 centers;
Fig. 7    shows EPR spectra of NV centers at X-band (9.9 GHz) with and without green laser illumination (< 5mW); and
Fig. 8    shows a schematic illustration of polarization transfer pathways in the present invention.

## DESCRIPTION OF PREFERRED EMBODIMENTS

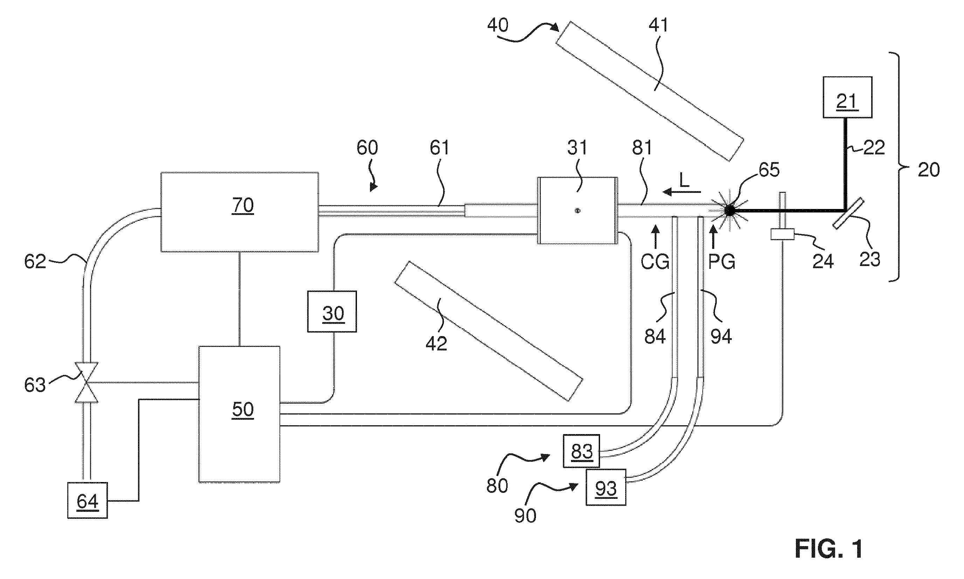

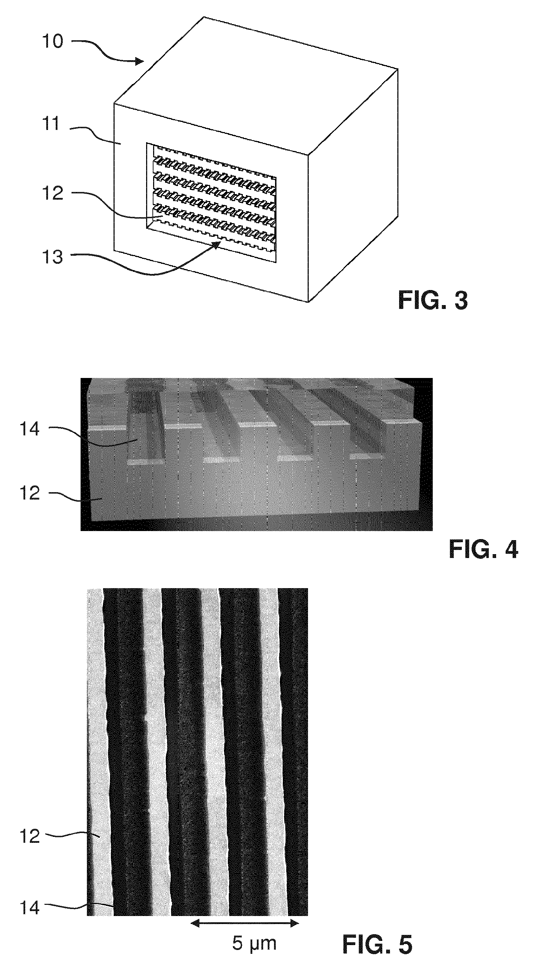

Figures 1-3 illustrate an exemplary embodiment of a spin polarizer system according to the present invention. The system comprises: a spin polarizer cell 10 (see Fig. 3) in the form of a shuttling container 11, which contains diamonds 12 and a sample 13 with an analyte; a light source 20; a microwave source 30 coupled to a microwave resonator 31; a magnet 40; a controller 50; a sample transfer mechanism 60 comprising a transfer tube 61; an NMR probe 70; and a cooling and heating device 80.

The various components of the spin polarizer system and the manner in which these components cooperate will be described in the following.

Spin polarizer cell

The spin polarizer cell 10 is schematically illustrated in Fig. 3. It comprises a container 11, which contains an arrangement of diamonds in the form of a stack of diamond plates 12. In the interspaces between the diamond plates, a liquid sample comprising an analyte 13 is received. In the present example the container 11 is made of glass or sapphire plates glued together to form a container of cuboid shape, closed by end plates (not shown) that are glued to the glass or sapphire plates. At least one portion of container 11 is transparent so as to enable a light beam to be coupled into spin polarizer cell 10.

For manufacturing the diamond plates, diamond crystals (preferably of type Ib) which contain P1 centers are treated to create a high density of NV centers. This treatment typically includes irradiation by electrons or ions to create a large number of vacancies and subsequent annealing to create NV centers. The diamond crystals are sliced into thin plates and stacked to enhance the surface area. Optionally, the plates are etched to create trenches in order to further increase surface area, as illustrated in Figs. 4 and 5. The trenches can have a width of 1-10 micrometers and a depth of 1-50 micrometers.

The diamond plates can include as-grown HPHT and CVD plates, laser-cut plates, polished plates, membrane plates made by ion implantation and lift-off, and membrane plates made by ion implantation, lift-off and overgrowth. Examples of suitable diamond plates are provided, e.g., in J. C. Lee, A. P. Magyar, D. O. Bracher, I. Aharonovich, and E. L. Hu, Fabrication of thin diamond membranes for photonic applications, Diamond and Related Materials 33, 45-48 (2013). The finished thickness of diamond plates can be between 100 nanometers (membranes) and 100 micrometers (as-grown or laser cut plates). Preferably the thickness of the diamond plates is between 5 and 50 micrometers. Instead of single-crystalline diamond plates, polycrystalline plates or plates made of diamond nanocrystals can be used, or a diamond powder may be employed.

Optionally, the liquid sample can contain nanodiamonds (which have P1 centers) and/or radicals (which have unpaired electron spins) as intermediate polarizing agents in addition to the analyte. As will be explained in more detail below, such intermediate polarizing agents mediate polarization transfer from NV centers or P1 centers in the diamond plates to the target spins in the analyte.

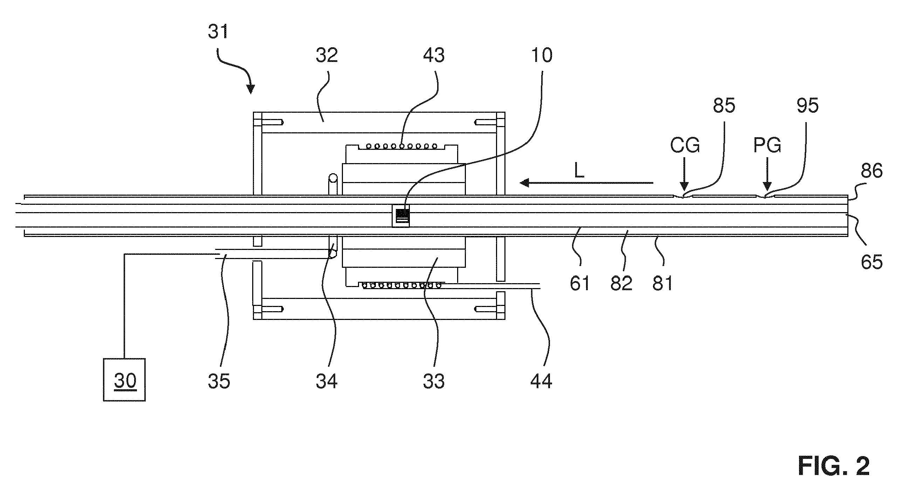

The spin polarizer cell 10 is initially placed in the center of the microwave resonator 31 (see Fig. 2).

Light source

The light source 20 typically comprises a laser 21, which generates a laser beam 22, optical elements such as optical fibers, lenses and/or mirrors 23 for guiding the laser beam 22 to the spin polarizer cell 10, and, optionally, a mechanical shutter 24.

The light source operates in a wavelength range between 400 and 650 nm. The light source can be a diode pumped solid-state laser (e.g. frequency-doubled Nd:YAG laser), a green light emitting diode, a gas laser (e.g. Argon-gas laser), a metal vapor laser (e.g. Helium-Mercury laser), or a gas discharge lamp (e.g. Xenon arc lamp). The light source can be operated in pulsed or continuous wave mode. Depending on the light source the modulation is established by internal control or the mechanical shutter 24. The optical power reaching the diamond plates is preferably between 10 mW and 100 W, more preferably between 100 mW and 10 W.

In the present example, the laser beam is guided along the longitudinal axis L of the transfer tube 61, entering the transfer tube 61 at its proximal end 65 and hitting the spin polarizer cell at one of its end faces. The respective end face of the spin polarizer cell 10 is at least semitransparent for the laser light.

Optionally, the spin polarizer cell 10 can comprise an optical cavity to enhance the effects of the optical irradiation. To this end, the container 11 of spin polarizer cell 10 can have end faces which act as semitransparent mirrors for the laser light coupled into the spin polarizer cell through one of the end faces. Light yield can further be improved by providing a reflective coating on the inside or outside of spin polarizer cell 10, or by forming selected walls of the container 11 of a reflective material, e.g., of a metal.

In other embodiments, light yield is improved by providing a reflective tube for receiving spin polarizer cell 10 in the center of the microwave resonator.

Magnet system

In the example of Figs. 1 and 2, the magnet system 40 comprises an electromagnet in the form of a Helmholtz pair of coils 41, 42 oriented obliquely to the longitudinal axis of the transfer tube 61. However, any other type of electromagnet or permanent magnet may be employed for creating a static magnetic field. In one embodiment, the static field created by the Helmholtz pair can be, e.g. approximately 50 mT, as explained in more detail below. In other embodiments, any other field strength can be created.

The term "static magnetic field" is to be understood as encompassing any field that varies on a time scale that is much longer than the time scale of the microwave radiation.

The magnet system 40 further includes a modulation coil 43 for adjusting and rapidly modulating the static magnetic field (at a modulation frequency of typically 1-1000 kHz), e.g. for carrying out field sweeps. The magnetic field generated by modulation coil 43 is preferably in the range of 0.1 to 10 mT.

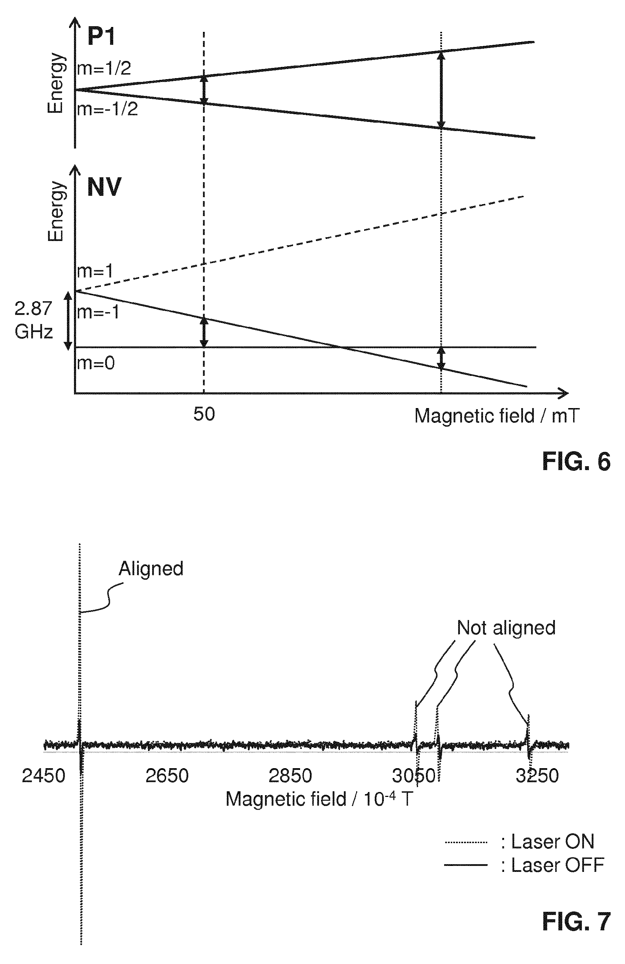

In one embodiment, the magnet system 40 produces a static magnetic field of approximately 50 mT at the center of the microwave resonator 31. The energy differences between two spin states in the NV centers and P1 centers match at about 50 mT when the NV axis is aligned to the static magnetic field. This is illustrated in Fig. 6, which shows an energy level diagram of NV centers and P1 centers as a function of the magnetic field. It can be seen that the Zeeman splitting between the $m_s = 0$ and $m_s = -1$ sublevels in the electronic ground state of the NV centers matches the Zeeman splitting between the electronic $m_s = -1/2$ and $m_s = 1/2$ sublevels in the P1 centers at about 50 mT. Spin polarization is transferred between the NV centers and the P1 centers at this condition by flip-flop transitions mediated by dipolar interactions between the NV and P1 spins.

In other embodiments, the magnet can be operated to produce a magnetic field that is different from approximately 50 mT, and polarization transfer between NV and P1 spins can be induced by applying microwave irradiation in addition to a static magnetic field.

Microwave source and resonator

The microwave resonator 31 that is employed in the present example is illustrated in Fig. 2. It comprises a loop gap resonator 33 and a coupling loop 34 for coupling microwaves into the loop gap resonator 33. A coaxial cable 35 connects the coupling loop 34 to the microwave source 30. The above-mentioned modulation coil 43 for modulating the static magnetic field surrounds the loop gap resonator 33. Current is fed from controller 50 to modulation coil 43 by a cable 44. The loop gap resonator 33, the coupling coil 34, and the modulation coil 43 are housed in a common housing 32.

In one embodiment, the magnet system 40 is operated to create a static magnetic field of approximately 50 mT. The resonant frequency (Larmor frequency) of P1 electron spins at ~50 mT is about 1.4 GHz. In this embodiment, the microwave source 30 and the microwave resonator 31 are preferably tuned to this frequency in order to excite P1 electron spins.

In other embodiments, the magnet system 40 is operated at a different magnetic field. In this case, the microwave source and microwave resonator are tuned to a different frequency, this frequency preferably again approximately corresponding to the P1 electron Larmor frequency at the magnetic field that is generated by the magnet system 40.

Sample transfer mechanism

The sample transfer mechanism 60 employed in the present example is a pneumatic shuttling system. The shuttling system comprises a transfer tube 61, tubing 62 connected to the distal end of the transfer tube 61, a control valve 63 in the tubing 62, and a source 64 of negative and positive pressure connected to the distal end of the tubing 62 for selectively providing a vacuum and pressurized gas in tubing 62.

Transfer tube 61 centrally traverses microwave resonator 31. Spin polarizer cell 10 is placed inside transfer tube 61. By applying a vacuum to the distal end of transfer tube 61, spin polarizer cell 10 can be transported to NMR probe 70. By applying positive pressure to the distal end of transfer tube 61, spin polarizer cell 10 can be shuttled back to the center of microwave resonator 31.

In other embodiments, an electromechanical shuttling system including an electromotor can be employed. Normally, a pneumatic system as shown in Figs. 1 and 2 is faster than an electromechanical shuttling system, while an electromechanical shuttling system is more accurate than a pneumatic system.

In yet other embodiments, a sample transfer mechanism can be dispensed with. This is true, in particular, if the magnetic field that is created by the magnet system is sufficiently high for subsequent NMR spectroscopy.

Cooling and heating system

The cooling and heating device 80 of the embodiment of Figs. 1 and 2 comprises a cooling tube 81, which surrounds the transfer tube 61, a source 83 of a cold gas CG (e.g., nitrogen gas that has been passed through a container with liquid nitrogen), and tubing 84 for connecting the source of cold gas to a lateral cold gas inlet 85 (see Fig. 2) in cooling tube 81.

The inner diameter of cooling tube 81 is larger than the outer diameter of transfer tube 61, defining an annular interspace 82 between transfer tube 61 and cooling tube 81. Thereby the cold gas CG that enters cooling tube 81 can pass into the interspace to cool transfer tube 61 and its interior. In this manner a temperature below the freezing point of the sample can be obtained in the inside of spin polarizer cell 10, so as to freeze the sample.

Freezing the sample is beneficial since polarization transfer from the diamond surface to the analyte and further within the analyte is more effective in the solid state than in the liquid state, as dipolar interactions are strongly reduced by molecular motions in the liquid state. In addition, the spin-lattice relaxation time of nuclear spins in solids is normally longer than that in liquids. Actively cooling the sample is further beneficial since relatively high optical power may be applied to the sample for polarizing the NV centers.

In order to melt the sample again, the sample is heated. Laser 21 of light source 20 can be employed for this purpose. By irradiating the spin polarizer cell with laser light at sufficiently high intensity, the sample is heated and eventually melts. Instead of using the same laser 21 as for polarizing the NV centers, a different laser (e.g., a $CO_2$ laser), an electric heater or heated gas can be employed. For examples of possible realizations, reference is made to C.-G. Joo, et al., In Situ Temperature Jump High-Frequency Dynamic Nuclear Polarization Experiments: Enhanced Sensitivity in Liquid-State NMR Spectroscopy, J. Am. Chem. Soc., 128, 9428-9432 (2006), and to M. Sharma, et al., Rapid-melt Dynamic Nuclear Polarization, J. Magn. Reson., 258, 40-48 (2015). The contents of these documents are incorporated herein in their entirety for teaching cooling and heating systems that may be employed in conjunction with the present invention.

In order to prevent fog or ice from forming in transfer tube 61 near its proximal end 65, the spin polarizer system of Figs. 1 and 2 further comprises a purging device 90. The purging device 90 comprises a source 93 of a warm and dry purge gas PG (e.g., dried nitrogen gas at room temperature) and tubing 94 which guides the purge gas PG to a lateral purge gas inlet 95 into cooling tube 81. The lateral purge gas inlet 95 is located near the cold gas inlet 85 and upstream from the cold gas inlet 85 with respect to the direction of propagation of laser beam 22. Thereby the purge gas prevents the cold gas from exiting cooling tube 81 at its proximal end 86, thereby preventing the proximal end region of transfer tube 61 from coming into direct contact with the cold gas. In this manner the proximal end region of transfer tube 61 is kept in a warm state. This effectively prevents the formation of fog and ice in the proximal end region of transfer tube 61, which would otherwise scatter laser beam 22.

Controller

The controller 50 coordinates the timing of the various actions in the presently proposed method. In the present embodiment, the controller is operatively connected to shutter 24 for the laser beam, to microwave source 30, to modulation coil 43, to valve 63, to pressure source 64, and to NMR probe 70. It controls these devices in a manner to carry out a process that is described in the following.

Description of the process

1. Freezing the sample

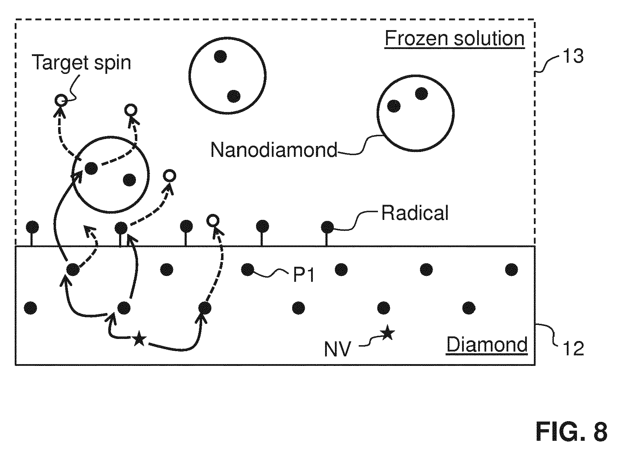

The liquid sample is frozen and kept cold. The resulting situation is illustrated in Fig. 8. The sample 13 forms a frozen solution in contact with the surface of diamond 12.

2. Preparation of NV polarization

NV centers are optically pumped by green light to prepare a large polarization of the NV centers in the diamond (>10%, ideally >90%). Figure 7 shows EPR spectra of NV centers at X-band (9.9 GHz) with and without green laser illumination. One orientation of NV axes is almost aligned to the external magnetic field while the other three are not aligned. An enhancement of ~10 (polarization of 0.8%) was obtained with less than 5 mW laser power. A polarization of more than 90% can be achieved by a 1 W laser source.

3. Polarization transfer to P1 electron spins (Fig. 8, solid arrows)

The enhanced polarization of NV spins is transferred to nitrogen substitutional defects (P1 centers) in the diamond at around 50 mT where the energy differences between two spin states of NV spins and P1 electron spins match (left dashed vertical line in Fig. 6). At this condition, flip-flops between an NV-P1 spin pair, which are induced by dipolar interactions, are energy conserving. No microwave irradiation is required for polarization transfer from NV spins to P1 spins, and the transfer rate is greatly enhanced.

Alternatively, an arbitrary magnetic field can be used if adequate microwaves are applied to assist polarization transfer (right dotted vertical line in Fig. 6). This polarization transfer can be achieved by one of the following two methods: 1) applying microwaves to meet the condition $\omega_{MW} = |\omega_{NV} - \omega_{P1}|$ where $\omega_{MW}$, $\omega_{NV}$ and $\omega_{P1}$, are the microwave frequency, one of the NV resonance frequencies involving the ms=0 substate of the ground state and the P1 resonance frequency, respectively, and 2) using the cross polarization technique of which condition is $B_{1,NV} = B_{1,P1}$ where $B_{1,NV}$ and $B_{1,P1}$ are the strengths of the microwave fields on NV and P1 spins, respectively, in a doubly-rotating frame. In the first method, $\omega_{MW} = 0$ when the magnetic field is about 50 mT. The second method requires two microwave frequencies and thus the apparatus will be more complicated.

The magnetic field can be swept by applying a current ramp to modulation coil 43 to cover the entire EPR linewidths or to compensate for field inhomogeneity. The typical modulation frequency is 1-1000 kHz and the field-sweep range is 0.1-10 mT. Typical sweep rates are 0.1-10'000 T/s. The sweep rate does not need to be constant.

Spin diffusion among P1 electron spins occurs simultaneously to hyperpolarize the P1 electron spins located close to the diamond surface. It is important to emphasize that the density of the surface P1 spins is much higher than that of surface NV spins, which results in a better polarization transfer efficiency to the target spins outside the diamond.

When the average distance between the nearest P1 centers is 3.6 nm (corresponding to a density of P1 centers of ~100 ppm or $10^{19}$-$10^{20}$ cm$^{-3}$) and the average distance between nearest NV centers is 7.9 nm (corresponding to an NV density of ~10 ppm), the spin diffusion coefficient is ~$10^4$ nm$^2$/ms. NV centers are pumped within 10 $\mu$s. Using the 1D diffusion model, the polarization of P1 centers is expected to reach a maximum after a diffusion time of around 0.2 ms, assuming a spin-lattice relaxation time ($T_1$) of P1 centers of 3 ms. The spin diffusion efficiency is ~0.9, which results in an expected P1 polarization of ~80%.

3a. Polarization transfer to intermediate spin species

The following two steps can optionally be included in the process in order to promote transfer of the hyperpolarization to outside the diamond.

a) Functionalizing the diamond surface with molecules containing unpaired electron spins (radicals). This allows for polarization transfer from the P1 spins to the electron spins of the radicals as an intermediate spin species, thereby hyperpolarizing the radical spins. Polarization can then be further transferred from the radical spins to the target spins by direct contact between the functionalized diamond surface and the analyte.

b) Doping the sample with radicals or nanodiamonds containing P1 centers. Also in this case the electron spins of the radicals or of the P1 centers in the nanodiamonds act as intermediate spin species for mediating polarization transfer to the target spins. Polarization is transferred from the P1 spins near the diamond surface to the intermediate spin species, and is further transferred from the intermediate spin species to the target spins during direct contact between the intermediate electron spins and the target spins as well as by long-range polarization transfer in the sample.

In both cases, polarization transfer from the hyperpolarized P1 centers to the additional electron spins in the radicals or nanodiamonds takes place by spin diffusion at an arbitrary static magnetic field, without requiring any microwave irradiation. Because the electron-electron spin coupling is about three orders of magnitude stronger than the electron-nuclear spin coupling, the polarization transfer efficiency is relatively high.

4. Polarization transfer to nuclear spins (Fig. 8, dashed arrows)

Polarization is then transferred from the P1 centers near the surface as well as from the intermediate spin species to the nuclear target spins in the sample by a dynamic nuclear polarization (DNP) technique with microwave irradiation.

In a preferred embodiment, polarization transfer occurs when the Hartmann-Hahn matching condition is achieved in the rotating frame of the electron spins and the laboratory frame of the nuclear spins ($\gamma_e \cdot B_1 = \gamma_n \cdot B_0$ where $\gamma_e$ and $\gamma_n$ are the gyromagnetic ratios of electron and nuclear spins, respectively, and $B_0$ and $B_1$ are the strengths of the static magnetic field and the microwave field, respectively). The EPR linewidth of electron spins is often broadened by hyperfine interactions, g-anisotropy or inhomogeneity of the magnetic field and thus the number of electron spins that meet the Hartmann-Hahn condition is limited. If the microwave frequency or the static magnetic field is swept, all electron spins can participate in the polarization transfer process (integrated solid effect). The matching condition in the latter case is $\omega_{\mathrm{eff}} = \sqrt{\{\gamma_e(B_0 - \Delta B_0)\}^2 + (\gamma_e B_1)^2} = \gamma_n B_0$ , where $\omega_{\mathrm{eff}}$ and $\Delta B_0$ are the frequency of the effective field and the offset of the static magnetic field produced by the field sweep. Here, the field sweep is performed sufficiently slowly in order to spin-lock electron spins on the effective field ("adiabatic sweep"). Typically, the sweep rate is 1-1000 kHz and the sweep range is 0.1-10 mT. Note that this technique is already established for DNP using photo-excited triplet states. About 70% of the polarization of electron spins can be transferred to nuclear spins. Reference is made to A. Henstra and W.Th. Wenckebach, Dynamic nuclear polarisation via the integrated solid effect I: theory, Mol. Phys., 112, 1761-1772 (2014), the contents of which are incorporated herein by reference in their entirety for disclosing a DNP technique suitable to be employed in the context of the present invention.

It is also possible to use a continuous-wave DNP technique which relies on well-known mechanisms such as solid effect, thermal mixing and cross effect. In this case, weaker microwaves are continuously irradiated to saturate electron spins. For example, in the case of solid effect, microwaves at $\omega_{MW} = \omega_e \pm \omega_n$ where $\omega_{MW}$, $\omega_e$ and $\omega_n$ are the microwave frequency, the electron Larmor frequency and the nuclear Larmor frequency, respectively, are applied to electron spins. The electron-nuclear dipolar coupling mixes the states in the electron spin subspaces and the forbidden zero- and double-quantum transitions at $\omega_{MW} = \omega_e \pm \omega_n$ become partially allowed transitions. Thus, the microwave irradiation at this frequency results in polarization transfer from electron spins to nuclear spins. For details, see R.A. Wind, et al., Applications of dynamic nuclear polarization in 13C NMR in solids, Prog. Nucl. Magn. Reson. Spectrosc., 17, 33-67 (1985).

Any other known pulsed or continuous-wave DNP technique can be employed.

5. Distribution of the polarization

Spin diffusion among the nuclear spins in the sample distributes the polarization throughout the sample. The efficiency is limited by the spin-lattice relaxation time $T_1$ of nuclear spins. Note that solid (frozen) samples generally have longer nuclear $T_1$ relaxation times than liquid samples. Assuming that the electron polarization is transferred to $^1$H spins, that the $^1$H spin diffusion coefficient is 1 nm$^2$/ms, and that $T_1$ = 10 s for the protons, and using the 1D diffusion model, the spin diffusion efficiencies are 0.096 for a 500 nm thick sample and 0.048 for a 1000 nm thick sample (after a polarization transfer time of 6 s). Thus, the final polarization of nuclear spins in the sample is expected to be 5.4% (500 nm sample) and 2.7% (1000 nm sample).

### 6. Polarization transfer to other nuclear species (optional)

Optionally, the polarization can be transferred from the hyperpolarized nuclear spins to other nuclear species which have longer spin-lattice relaxation time $T_1$. For instance, the spin-lattice relaxation time of $^{13}$C spins is typically much longer than that of $^1$H spins and therefore $^{13}$C spins can store polarization for longer time. This often results in greater total polarization once the sample is in the conventional NMR spectrometer unit, since the process including sample shuttling requires certain time to complete and the polarization will decay if the $T_1$ is short. Polarization transfer between two different nuclear spin species in solids can be performed by cross polarization, as it is well known in the field.

### 7. Repetition

Steps 2) - 6) are optionally repeated until the timescale of the $T_1$ of nuclear spins in order to accumulate polarization in nuclear spins. Larger polarization is achieved when the $T_1$ of nuclear spins is longer.

### 8. Sample melt

The frozen sample is rapidly melted by the cooling and heating device 80.

### 9. Sample shuttling

The sample is shuttled into a conventional NMR system for NMR measurements. This can be done pneumatically by sample transfer mechanism 60. Alternatively, this can be performed electromechanically using a linear motor or a similar device.

### 10. Recycling

The used sample can be shuttled back to prepare hyperpolarization again and repeat NMR measurements.

The spin polarization of $^1$H spins at 7 T at room temperature is 0.0024%. The enhancement factor possible with the presently proposed method will be > 2,000 (= 5.4/0.0024). Benchtop NMR systems typically operate at 1 T and room temperature, resulting in a $^1$H polarization of 0.00036%. In this case, an enhancement factor of ~15,000 is expected. Finally, the method can be compared to a state-of-the-art hyperpolarization method, as described in J. H. Ardenkjær-Larsen, et al., Increase in signal-to-noise ratio of > 10,000 times in liquid-state NMR, Proc. Natl. Acad. Sci., 100, 10158-10163 (2003). Therein, a $^{13}$C polarization of ~40% was achieved by cooling the system down to 1.2 K and transferring the polarization of electron spins to $^{13}$C spins. However, the polarization transfer time was > 4 hours due to the inefficient DNP mechanism. Thus, the sensitivity enhancement efficiency 'per unit time' will be > 300 times larger in our method than in this state-of-the-art method. Furthermore, the presently proposed apparatus is significantly simpler and more cost efficient.

While a preferred embodiment of the present invention has been described, various modifications are possible without leaving the scope of the present invention, and it is to be understood that the present invention is not limited to the above-described embodiments.

LIST OF REFERENCE SIGNS

| | |
|---|---|
| 10 | spin polarizer cell |
| 11 | container |
| 12 | diamond |
| 13 | sample |
| 14 | trench |
| 20 | light source |
| 21 | laser |
| 22 | laser beam |
| 23 | optical element |
| 24 | mechanical shutter |
| 30 | microwave source |

| 31 | microwave cavity |
| 32 | housing |
| 33 | loop gap resonator |
| 34 | coupling loop |
| 35 | coaxial cable |
| 40 | magnet system |
| 41, 42 | Helmholtz coil |
| 43 | modulation coil |
| 44 | cable |
| 50 | controller |
| 60 | sample transfer mechanism |
| 61 | transfer tube |
| 62 | tubing |
| 63 | valve |
| 64 | source of pressure |
| 65 | proximal end of transfer tube |
| 70 | NMR probe |
| 80 | cooling and heating device |
| 81 | cooling tube |
| 82 | annular interspace |
| 83 | source of cold gas |
| 84 | tubing |
| 85 | cold gas inlet |
| 86 | proximal end of cooling tube |
| 90 | purging device |
| 93 | source of purge gas |
| 94 | tubing |
| 95 | purge gas inlet |

**Claims**

1.  A method for polarizing nuclear target spins in an analyte, the method comprising:

    (a) providing at least one diamond (12) comprising a plurality of nitrogen-vacancy centers (NV) and a plurality of substitutional nitrogen centers (P1), the diamond (12) defining a diamond surface;
    (b) bringing a sample (13) comprising the analyte into contact with the diamond surface;
    (c) irradiating the nitrogen-vacancy centers (NV) with light to produce polarized electron spins in the nitrogen-vacancy centers (NV);
    (d) inducing polarization transfer from the nitrogen-vacancy centers (NV) to substitutional nitrogen centers (P1) in the diamond;
    (e) inducing direct or indirect polarization transfer from the substitutional nitrogen centers (P1) in the diamond to the target spins in the analyte; and
    (f) optionally repeating steps (c)-(e).

2.  The method of claim 1, wherein the polarization transfer from the nitrogen-vacancy centers (NV) to the substitutional nitrogen centers (P1) in step (c) is induced by applying a static magnetic field to the diamond (12) to match a Zeeman splitting of the electronic spins of the nitrogen-vacancy centers (NV) with a Zeeman splitting of the electronic spins of the substitutional nitrogen centers (P1), or by applying a combination of a static magnetic field and microwave irradiation to the diamond (12).

3.  The method of claim 1 or 2,

    wherein the sample (13) is brought into contact with the diamond surface while the sample (13) is in a liquid state, wherein the sample (13) is frozen after it has been brought into contact with the diamond surface;
    wherein the polarization transfer from the substitutional nitrogen centers (P1) in the diamond to the target spins is induced while the sample (13) is in a frozen state; and
    wherein the sample (13) is melted again after polarization transfer from the substitutional nitrogen centers (P1) to the target spins has been effected.

4. The method of any one of the preceding claims, further comprising:

   shuttling the sample into a magnetic resonance probe (70).

5. The method of any one of the preceding claims,

   wherein the diamond surface is functionalized with radicals, and
   wherein the polarization transfer from the substitutional nitrogen centers (P1) in the diamond (12) to the target spins comprises:

   (e1) a first polarization transfer from near-surface substitutional nitrogen centers (P1) in the diamond to the radicals, and
   (e2) a second polarization transfer from the radicals to the target spins.

6. The method of any one of the preceding claims,

   wherein the liquid sample further comprises at least one of radicals and nanodiamonds comprising substitutional nitrogen centers; and
   wherein the polarization transfer from the substitutional nitrogen centers (P1) in the diamond (12) to the target spins comprises:

   (e1) a first polarization transfer from the substitutional nitrogen centers (P1) in the diamond to the radicals or to the substitutional nitrogen centers in the nanodiamonds; and
   (e2) a second polarization transfer from the radicals or from the substitutional nitrogen centers in the nanodiamonds to the target spins.

7. An apparatus for polarizing nuclear target spins in an analyte, the apparatus comprising:

   a spin polarizer cell (10) comprising at least one diamond (12), the diamond (12) comprising a plurality of nitrogen-vacancy centers (NV) and a plurality of substitutional nitrogen centers (P1), the spin polarizer cell (10) being configured to receive a liquid sample (13) comprising the analyte;
   a light source (20);
   a microwave source (30);
   a microwave resonator (31) coupled to the microwave source (30) and configured to receive the spin polarizer cell (10);
   a magnet system (40) configured to create a static magnetic field inside the microwave resonator (31), the magnet system optionally comprising a modulation coil (43) configured to sweep the static magnetic field; and
   a controller (50) configured to control the light source (20), the microwave source (30) and optionally the magnet system (40) in such a manner so as to carry out the following method:

   (a) activating the light source (20) to irradiate the nitrogen-vacancy centers (NV) with light to produce polarized electron spins in the nitrogen-vacancy centers (NV);
   (b) operating the microwave source (30) and the magnet system (40) in such a manner that polarization transfer from the nitrogen-vacancy centers (NV) to substitutional nitrogen centers (P1) in the diamond (12) is induced;
   (c) operating the microwave source (30) and the magnet system (40) in such a manner that direct or indirect polarization transfer from the substitutional nitrogen centers (P1) in the diamond (12) to the target spins is induced; and
   (d) optionally repeating steps (a)-(c).

8. The apparatus of claim 7, wherein the apparatus comprises a cooling and heating device (80) for selectively freezing and melting the sample, and wherein the controller (50) is configured to control the cooling and heating device (80) in such a manner so as to carry out the following steps:

   operating the cooling and heating device (80) to freeze the sample before polarization transfer from the nitrogen-vacancy centers (NV) to substitutional nitrogen centers (P1) in the diamond (12) is induced; and

operating the cooling and heating device (80) to melt the sample (13) after polarization transfer from the substitutional nitrogen centers (P1) to the target spins has been effected.

9. The apparatus of claim 7 or 8, comprising a sample transfer mechanism (60), the sample transfer mechanism (60) comprising a transfer tube (61) configured to receive the spin polarizer cell (10), the sample transfer mechanism (60) being configured to transfer the sample container (11) to a magnetic resonance probe (70).

10. The apparatus of claims 8 and 9, wherein the cooling and heating device (80) comprises:

a cooling tube (81), the cooling tube (81) surrounding the transfer tube (61) so as to define an annular interspace (82) between the transfer tube (61) and the cooling tube (81);
a cold gas source (83) configured to pass cold gas (CG) into the interspace (82) so as to cool the transfer tube (61) and the spin polarizer cell (10) received therein, and, optionally,
a purging device (90) configured to pass a purge gas (PG) into a proximal end region (84) of the cooling tube (81) so as to prevent the cold gas (CG) from exiting the cooling tube (81) at a proximal end (86) of the cooling tube.

11. A spin polarizer cell (10) comprising:

a sample container (11) having at least one wall portion that is transparent to visible light; and
an arrangement of diamonds disposed inside the sample container so as to receive a liquid sample (13) between the diamonds.

12. The spin polarizer cell of claim 11, wherein the arrangement of diamonds (12) comprises a stack of diamond plate, each diamond plate comprising a plurality of nitrogen-vacancy centers (NV) and a plurality of substitutional nitrogen centers (P1), the diamond plates being arranged so as to receive the liquid sample (13) between the diamond plates, wherein preferably each diamond plate has a thickness of 0.5 to 100 micrometers.

13. The spin polarizer cell (10) of claim 12 wherein each diamond plate comprises a plurality of parallel trenches (14).

14. The spin polarizer cell (10) of any one of claims 11-13, wherein each of the diamonds (12) has at least one surface that is functionalized with radicals.

15. The spin polarizer cell of any one of claim 11-14, further comprising a sample (13) comprising an analyte having nuclear target spins, the sample (13) further comprising radicals or nanodiamonds containing P1 centers.

FIG. 1

EP 3 264 124 A1

FIG. 2

**FIG. 3**

**FIG. 4**

5 µm    **FIG. 5**

FIG. 6

FIG. 7

Frozen solution 13
Target spin
Nanodiamond
Radical
P1
NV
Diamond 12

FIG. 8

Europäisches
Patentamt

European
Patent Office

Office européen
des brevets

# EUROPEAN SEARCH REPORT

**Application Number**

EP 16 17 7281

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2014/165845 A1 (UNIV CITY NEW YORK RES FOUND [US]) 9 October 2014 (2014-10-09)<br>* paragraphs [0055], [0068], [0083]; claim 1 * | 1,2,4,7<br><br>3,5,6,<br>8-10 | INV.<br>G01R33/28<br>G01R33/62<br><br>ADD.<br>G01N24/12<br>G01R33/32 |
| A | US 2015/008917 A1 (KENTGENS ARNOLD PETER MARIA [NL] ET AL)<br>8 January 2015 (2015-01-08)<br>* paragraph [0044] * | 1,3,7-9 | |
| E | WO 2016/188557 A1 (UNIV ULM [DE])<br>1 December 2016 (2016-12-01)<br>* page 12, paragraph 2 - page 13, paragraph 3 *<br>* page 15, paragraph 2 * | 1 | |

**TECHNICAL FIELDS
SEARCHED        (IPC)**

G01R
G01N

~~The present search report has been drawn up for all claims~~

| Place of search | Date of completion of the search | Examiner |
|---|---|---|
| Munich | 15 December 2016 | Skalla, Jörg |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

      .........................................................
& : member of the same patent family, corresponding
      document

EPO FORM 1503 03.82 (P04C01)

Europäisches
Patentamt

European
Patent Office

Office européen
des brevets

Application Number

EP 16 17 7281

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-10

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 16 17 7281

The Search Division considers that the present European patent application does not comply with the requirements of unity of invention and relates to several inventions or groups of inventions, namely:

```
   1. claims: 1-10

         Method and apparatus for polarizing nuclear target spins
                   ---

   2. claims: 11-15

         Spin polarizer cell
                   ---
```

## ANNEX TO THE EUROPEAN SEARCH REPORT
## ON EUROPEAN PATENT APPLICATION NO.

EP 16 17 7281

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2016

| Patent document cited in search report | | Publication date | Patent family member(s) | | Publication date |
|---|---|---|---|---|---|
| WO 2014165845 | A1 | 09-10-2014 | CA | 2907773 A1 | 09-10-2014 |
| | | | EP | 2981839 A1 | 10-02-2016 |
| | | | US | 2016054402 A1 | 25-02-2016 |
| | | | WO | 2014165845 A1 | 09-10-2014 |
| US 2015008917 | A1 | 08-01-2015 | EP | 2795355 A1 | 29-10-2014 |
| | | | US | 2015008917 A1 | 08-01-2015 |
| | | | WO | 2013092996 A1 | 27-06-2013 |
| WO 2016188557 | A1 | 01-12-2016 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20160054402 A1
- US 20160061914 A1

### Non-patent literature cited in the description

- **D. ABRAMS et al.** Dynamic Nuclear Spin Polarization of Liquids and Gases in Contact with Nanostructured Diamond. *Nano Lett.,* 2014, vol. 14, 2471-2478
- **Q. CHEN et al.** Optical hyperpolarization of C nuclear spins in nanodiamond ensembles. *Phys. Rev. B,* 2015, vol. 92, 184420
- **J. P. KING et al.** Room-temperature in situ nuclear spin hyperpolarization from optically pumped nitrogen vacancy centres in diamond. *Nat. Commun.,* 2015, vol. 6, 8965
- **R. HANSON et al.** Polarization and Readout of Coupled Single Spins in Diamond. *Phys. Rev. Lett.,* 2006, vol. 97, 87601
- **C. BELTHANGADY et al.** Dressed-State Resonant Coupling between Bright and Dark Spins in Diamond. *Phys. Rev. Lett.,* 2013, vol. 110, 157601
- **J. C. LEE ; A. P. MAGYAR ; D. O. BRACHER ; I. AHARONOVICH ; E. L. HU.** Fabrication of thin diamond membranes for photonic applications. *Diamond and Related Materials,* 2013, vol. 33, 45-48
- **C.-G. JOO et al.** In Situ Temperature Jump High-Frequency Dynamic Nuclear Polarization Experiments: Enhanced Sensitivity in Liquid-State NMR Spectroscopy. *J. Am. Chem. Soc.,* 2006, vol. 128, 9428-9432
- **M. SHARMA et al.** Rapid-melt Dynamic Nuclear Polarization. *J. Magn. Reson.,* 2015, vol. 258, 40-48
- **A. HENSTRA ; W.TH. WENCKEBACH.** Dynamic nuclear polarisation via the integrated solid effect I: theory. *Mol. Phys.,* 2014, vol. 112, 1761-1772
- **R.A. WIND et al.** Applications of dynamic nuclear polarization in 13C NMR in solids. *Prog. Nucl. Magn. Reson. Spectrosc.,* 1985, vol. 17, 33-67
- **J. H. ARDENKJÆR-LARSEN et al.** Increase in signal-to-noise ratio of > 10,000 times in liquid-state NMR. *Proc. Natl. Acad. Sci.,* 2003, vol. 100, 10158-10163